# EUROPEAN PATENT SPECIFICATION

(11) **EP 0 438 273 B1**
(45) Date of publication and mention of the grant of the patent: **11.09.1996**
(21) Application number: 91300295.2
(22) Date of filing: 16.01.1991
(51) Int. Cl.: G06F 11/20

(54) **Semiconductor memory devices having column redundancy**
Halbleiterspeichergeräte mit Spaltenredundanz
Dispositif de mémoire à semi-conducteur à redondance de colonne

(30) Priority: 18.01.1990 JP 9104/90
(43) Date of publication of application: 24.07.1991
(73) Proprietor: SONY CORPORATION, Tokyo 141 (JP)
(72) Inventor: Watanabe, Makoto, c/o Patents Division Sony Corp., Shinagawa-ku, Tokyo 141 (JP)
(74) Representative: Cotter, Ivan John

(56) References cited:
- EP-A- 0 315 257
- US-A- 4 868 789

## Description

This invention relates to semiconductor memory devices having column redundancy. Such devices may for example be used as video memories in which data are inputted and outputted serially, and the data are converted into or from parallel data therein.

In general, a video memory such as a field memory has a memory cell array composed of DRAM type cells and performs serial-parallel conversion and parallel-serial conversion during writing and reading, respectively, by means of a register, for inputting or outputting the serial data.

With such a video memory, defects tend to occur in memory cells, and a redundancy circuit is provided for rescuing the erroneous bits where the defect has occurred. In general, the column decoder is dispensed with in a video memory because one-row data are written or read out collectively to or from the memory cell array. Therefore, if the defective memory cell column is exchanged in the redundancy circuit, since the addresses cannot be specified directly to the redundancy circuit, it becomes necessary to add various circuits.

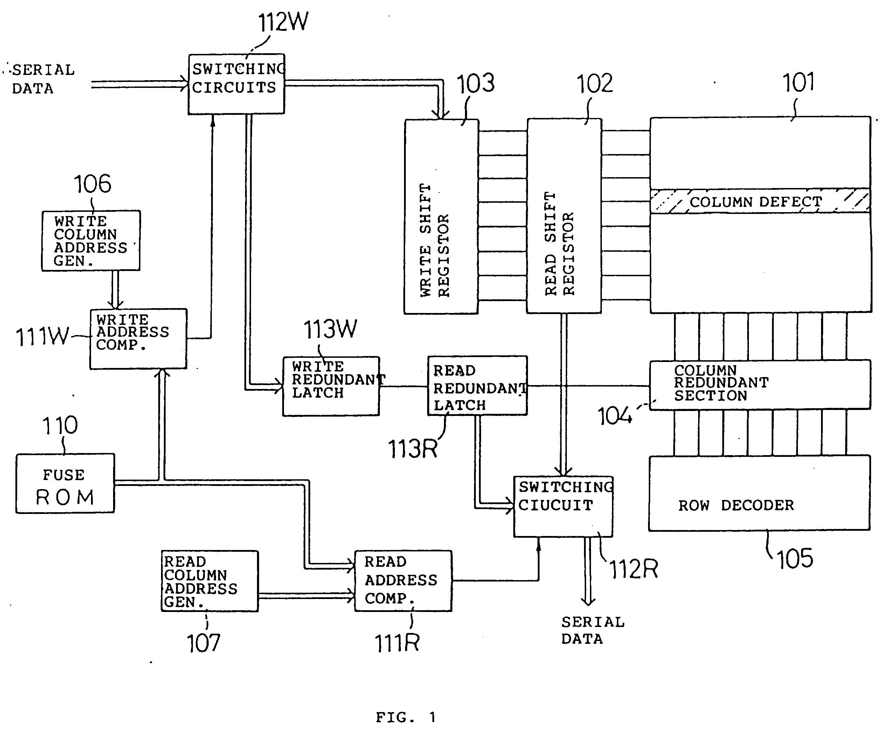

Figure 1 shows portions of an example of a previously proposed memory device having a column redundant section. A read shift register 102 and a write shift register 103 are provided in a RAM section 101 having a memory cell array for data storage. In the read shift register 102, data are transmitted in parallel from the RAM section 101, and thence outputted serially. Data are inputted serially in the write shift register 103 and transferred in parallel to the RAM section 101. The RAM section 101 and a column redundant section 104 provided thereat are associated with a row decoder 105 to effect row selection. The column redundant section 104 rescues column defects in the RAM section 101 by row-by-row substitution, and data to be stored intrinsically in the column defective portion are stored in the column redundant section 104. For such substitution, the video memory device is provided with a fuse ROM 110 for storing column-defective column data (column address), a write address comparator circuit 111W, a read addresses comparator circuit 111R, a write switching circuit 112W, a read switching circuit 112R, a write redundancy latch 113W and a read redundancy latch 113R. In the comparator circuits 111W and 111R, address data from address generators 106 and 107 are compared with column-defective column data from the fuse ROM 110 and, in case of coincidence of these data, the switching circuits 112W and 112R are switched to the latch side. As a result, data are written into the column redundant section 104, and data are read out from the column redundant section 104.

With this video memory device, the fuse ROM 110, the comparator circuits 111R and 111W, and the switching circuits 112W and 112R are required for controlling the column redundant section 104, so that a corresponding area on the chip has been required.

Also, the read-out erroneous data are replaced by the redundant data by the switching circuit 112R with consumption of excess time.

Document EP-A-0 315 257 discloses a memory device having redundant storage columns for replacing faulty storage columns in a regular memory array.

According to the present invention there is provided a semiconductor memory device for storing video data, the device comprising a memory cell array including a plurality of memory cells arrayed in a matrix comprising a plurality of rows and a plurality of columns, and the memory device being characterised by;
a shift register including a plurality of serially connected flip-flops for shifting data therein, said shift register being connected in parallel with said columns of the memory cell array via respective bit lines and said shift register being capable of inputting or outputting data in parallel from or to said memory cell array and also being capable of outputting or inputting data in series to or from the outside of the device; and
control means for generating control signals to control the operation of said shift register such that the data in said shift register are passed through to the next of said serially connected flip-flops without latching at one of said flip-flops which is connected by one of said bit lines to a defective column, the control means being so operative that said bit line connecting said one of said flip-flops to said defective column of said memory cell array is cut-off by one of said control signals, and said one of said flip-flops is inhibited from holding the data by another of said control signals.

According to one embodiment of the present invention, a semiconductor memory device comprises a register containing a plurality of serially connected flip-flops, the register being capable of inputting and outputting data in parallel to or from an array of memory cells and also being capable of inputting and outputting data in series to or from the outside of the chip. The memory device includes a redundant column section, and a redundant latch section associated with the redundant column section, and data are transferred in idle in the flip-flop circuit of the register associated with the memory cell column having an erroneous bit. The transferring in idle or the passing of the data is controlled by an erroneous bit data storage circuit in which the column data of the erroneous bits are stored.

The invention will now be described by way of example with reference to the accompanying drawings, throughout which like parts are referred to by like references, and in which:
Figure 1 is a block diagram showing an example of a previously proposed memory device;
Figure 2 is a block diagram showing an embodiment of memory device according to the present invention;
Figure 3 is a circuit diagram showing the terminal section of a shift register;
Figure 4 is a circuit diagram of a signal generating circuit for generating signals for operating the circuit of Figure 3;
Figure 5 is a circuit diagram showing a modification of the terminal section of the shift register; and
Figure 6 is a circuit diagram of a signal generating circuit for generating signals for operating the circuit of Figure 5.

### First embodiment

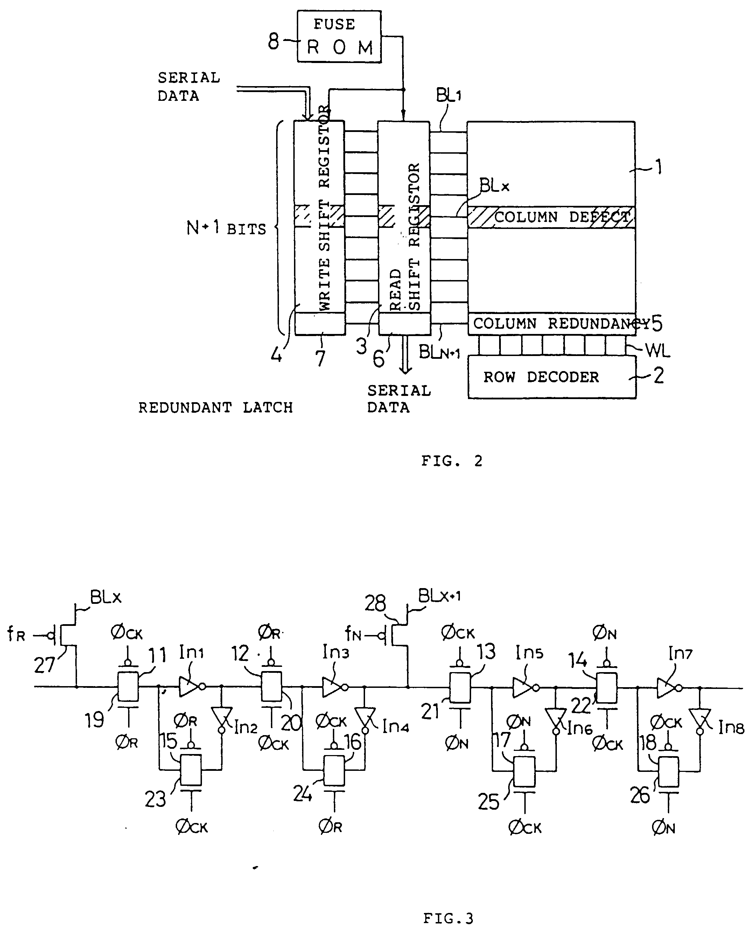

Embodiments of memory device according to the present invention have a general construction as shown in Figure 2 for rescuing column defects.

First explaining the circuit construction, the memory device includes a memory cell array 1 having DRAM type cells, the memory cells being arrayed in a matrix configuration in the memory cell array 1. The number of columns of the memory cells is (N+1), where N is an integer. The end column of these (N+1) columns is a column redundant section 5 for rescuing column defects.

A plurality of word lines WL are provided for row selection in the memory cell array 1, these word lines being formed in a parallel pattern at the gates of access transistors, not shown, of the memory cells. The word lines WL are connected to a row decoder 2 which raises the potential of the word line WL to be selected in accordance with address signals.

The memory cell array 1 is also provided with a plurality of bit lines BL₁, ..., BL_{N+1} extending in parallel with one another in a direction normal to the word lines WL. These bit lines are used to effect data read-out. The bit lines BL₁, ..., BL_{N+1} are connected to capacitances in the memory cells by means of access transistors so that their voltages are amplified by sensing amplifiers, not shown. In the present embodiment, since only one redundancy bit line is provided, the number of bit lines is (N+1). The number of redundant bit lines need not be one, but may be more, in which case a number of column-defective memory cell columns corresponding to the number of redundant bit lines may be replaced.

The bit lines BL₁, ..., BL_{N+1} are connected to the read shift register 3 and the write shift register 4. The read shift register 3 is used for outputting the parallel data from the bit lines BL₁, ..., BL_{N+1} after conversion thereof into serial data. As will be explained subsequently, the read shift register 3 is composed of (N+1) series connected flip-flop circuits, the end part of which is a redundant latch section 6 for latching data from the column redundant section 5. The write shift register 4 is used for converting serial data from outside into parallel data, and writing the converted data into memory cells by means of the bit lines BL₁, ..., BL_{N+1}. The write shift register 4 is similarly composed of (N+1) serially connected flip-flop circuits, the end part of which is a redundant latch section 7 for latching data to be transferred to the column redundant section 5.

The memory device includes a fuse ROM 8 forming erroneous bit data storage means for storing column data for defective bits, that is the defective column address. The fuse ROM 8 is a circuit for storage of address signals by the pattern of fuse connection and disconnection of the previously melted fuse or fuses, such that, if the column with a column address x is defective, as indicated by hatching in Figure 2, a signal to the effect that the column of the x′th address is in error is outputted from the fuse ROM 8.

With this memory device, if the column of the x′th address is defective, data are transferred in idleness in the corresponding portions of the shift registers 3 and 4 and data entry or outputting is not performed between the shift register and the memory cell having the x′th address, to prevent the defective bit from occurring. The hatched areas in the shift registers 3 and 4 represent diagrammatically the portions where idle transfer is performed.

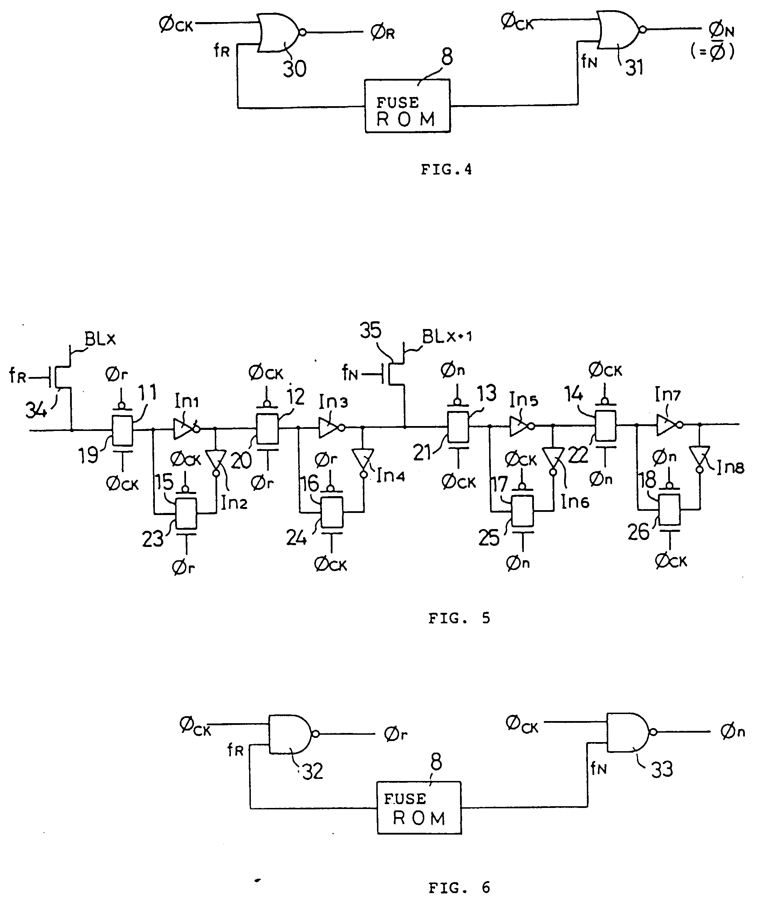

A shift register will be explained in more detail by referring to Figures 3 and 4.

As shown in Figure 3, the shift register is so arranged and constructed that a forward stage D-flip-flop and a rear stage D-flip-flop are associated with each bit line. Inverters In₁ to In₈ are arranged to form the D-flip-flops. That is, a set of inverters In₁ and In₂, a set of inverters In₃ and In₄, a set of inverters In₅ and In₆, and a set of inverters In₇ and In₈ have their input terminals connected to the output terminals to form the flip-flops. Between the adjoining flip-flops, there are provided CMOS switch type transfer gates formed by pMOS transistors 11 to 14 and nMOS transistors 19 to 22. In the latch loops of the flip-flops, there are also provided CMOS switch type transfer gates which are formed by pMOS transistors 15 to 18 and nMOS transistors 23 to 26. To the input side of the forward stage flip-flop are connected bit lines BLₓ and BLₓ₊₁ by means of pMOS transistors 27 and 28 functioning as switches.

The register operation differs between the flip-flop for the bit line BLₓ of the memory cell column where column defects have occurred and the flip-flop for the bit line BLₓ₊₁ of the memory cell column performing normal operation. Above all, idle transfer or passing occurs in the flip-flop of the bit line BLₓ.

Figure 4 shows a signal generator for actuating the transistors 11 to 26. The fuse ROM 8 generates a signal f_{R} which is to be supplied to the flip-flop of the bit line BLₓ of the memory cell column where column defects have occurred, while generating a signal f_{N} which is to be supplied to the flip-flop of the bit line BLₓ₊₁ of the memory cell column performing a normal operation. The signal f_{R} is always at an "H" (high) level and is, in effect, a defective column address signal. Conversely, the signal f_{N} is always at an "L" (low) level and is supplied to all of the regular memory cell columns other than the bit line BLₓ. The signals f_{R} and f_{N} are supplied to NOR gates 30 and 31, to the other input terminals of which a clock signal φ_{CK} alternating between the "H" level and the "L" level at a constant period. Thus the output of the NOR gate 30, supplied with the signal f_{R}, is always a signal φ_{R} at the "L" level, whereas the output of the NOR gate 31, supplied with the signal f_{N}, is always a signal φ_{N} inverted relative to the clock signal φ_{CK}.

Explaining the operation of the flip-flop which performs normal operation, the signal f_{N} which is always at the "L" level is supplied to the gate of the transistor 28 between the bit line BLₓ₊₁ and the flip flop, so that the transistor 28 is always turned on. The signal φ_{CK} is supplied to the gate of the transistor 13 ahead of the forward stage flip-flop, while the signal φ_{N} is supplied to the gate of the transistor 21 so that, when the signal φ_{CK} is at the "L" level, this CMOS switch is turned on. Thus the inverter In₅ generates an inverted output, while the inverter In₆ generates an inverted output of said inverted output. However, when the signal φ_{CK} is at the "L" level, the transistors 14 and 17 and the transistors 22 and 25 are all turned off so that the data are not latched. Next, when the signal φ_{CK} rises from the "L" level to the "H" level, the transistor 17 and the transistor 25 are turned on, while the transistor 13 and the transistor 21 are turned off, so that the data are latched. Simultaneously, the transistor 14 and the transistor 22 are turned on, so that data are transferred from the forward stage flip-flop to the rear stage flip-flop, and the output of the inverter In₇ is at the same level as the input of the inverter In₅. The signal φ_{CK} falls from the "H" level to the "L" level and the rear stage D-flip-flop is latched by means of the MOS transistors 18 and 26, at the same time that the transistors 14 and 22, acting as switches between the forward stage and the rear stage, are turned off, while the transistors 13 and 21, acting as the transfer gates at the input side of the forward stage flip-flop are turned on. Data are transferred by the above described cyclic operation. Meanwhile, the operation of the flip-flop corresponding to the normal memory cell is the same as that of a known shift register.

The idle transfer operation of the flip-flop associated with the bit line BLₓ of the memory cell column suffering from column defects is hereinafter explained. First, the signal f_{R} which is always at the "H" level is supplied to the gate of the transistor 27 between the bit line BLₓ and the flip-flop, so that the transistor 27 is always turned off. This is tantamount to the bit line BLₓ with the defective column being disconnected. The flip-flop, transferring in idleness, should intrinsically be supplied with the signal φ_{N}, is supplied with the signal φ_{R} which is always at the "L" level, so that it performs an idle transfer operation without data latching. That is, of the flip-flops associated with the bit lines BLₓ, the transistors 19 and 24 are always turned off, while the transistors 12 and 15 are always turned on. Since the transistor 12 is always turned on, the signal supplied to the inverter In₁ directly appears at the output of the inverter In₃, without regard to the level of the signal φ_{CK}. Thus the data are always latched in the forward stage flip-flop and data are transmitted to the output of the inverter In₃ when the transistor 11 is turned on. This means that, when the flip-flop at the forward stage of the bit line BLₓ is in the sampling state, the flip-flop of the forward stage of the bit line BLₓ₊₁ is also in the sampling state simultaneously with the same data, so that data are transferred by skipping over one column register.

Thus, with this memory device, data are transferred at the register associated with the memory cell column suffering from a column defect as passing through the register without latching. Data are transferred in excess through one register over the shift registers 3 and 4, while redundant latches 6 and 7 positively latch these data between the redundant column section 5. Thus the circuit for switching control, such as switching circuits or address comparators may be eliminated to save area on the chip. Since these circuits are eliminated, high-speed read-out is also enabled.

Meanwhile, if there is no defective column, idle transfer may be made between the redundant latch sections 6 and 7. Although one memory cell column with the defective column is replaced by one column, this is not limitative and a plurality of columns of column redundant sections may be provided to cope with several defective columns. The number of shift registers is not limited to one for each of the read and write shift register.

### Second embodiment

The second embodiment to be described is a modification of the first embodiment, in which the signal to be supplied to the transfer gate of the shift register is modified. The circuit construction of the shift register shown in Figure 5 is the same as the circuit construction shown in Figure 3 except that the pMOS transistors 27 and 28 are changed to nMOS transistors 34 and 35. The same reference numerals are used, and detailed description is omitted.

With this second embodiment, signals are generated by the circuit shown in Figure 6. A fuse ROM 8 generates a signal f_{N} which is always "H" to the normal memory cell column, while generating a signal f_{R} which is always "L" to the defective memory cell column. This signal f_{R} is to be the defective column address signal. These signals are supplied to NAND gates 32 and 33. A clock signal φ_{CK} is also supplied to the other input terminals of the NAND gates 32 and 33. This clock signal φ_{CK} is a signal alternating between the "H" level and the "L" level at a constant period. The output of the NAND gate 33, supplied with the signal f_{N} which is always at the "H" level, is a signal φₙ which is inverted from the clock signal φ_{CK}. The output of the NAND gate 32, supplied with the signal f_{R} which is always at the "L" level, is a signal φᵣ which, irrespective of the clock signal φ_{CK}, is always at the "H" level.

As shown in Figure 5, the circuit construction of the present embodiment is such that latching occurs with falling of the clock signal φ_{CK}, and control is made by the clock signal φ_{CK} and the signals φᵣ and φₙ generated at the NAND gates 32 and 33.

With this embodiment, the nMOS transistor 20 between the forward and rear stages of the D-flip-flop associated with the defective memory cell column is always turned on by the signal φᵣ. Thus the data are not latched by, but passed through the nMOS transistor through which the data is transferred in idleness. As a result, the circuitry for switching control, such as switching circuits or address comparators, may be eliminated to save chip area. Since the control circuits are unnecessary, high-speed read-out is also enabled.

## Claims

1. A semiconductor memory device for storing video data, the memory device comprising a memory cell array (1) including a plurality of memory cells arrayed in a matrix comprising a plurality of rows and a plurality of columns, and the memory device being characterised by;
a shift register (3, 4) including a plurality of serially connected flip-flops for shifting data therein, said shift register (3, 4) being connected in parallel with said columns of the memory cell array (1) via respective bit lines (BL₁ to BL_{N+1}) and said shift register (3, 4) being capable of inputting or outputting data in parallel from or to said memory cell array (1) and also being capable of outputting or inputting data in series to or from the outside of the device;and
control means (8, 30, 31; 8, 32, 33) for generating control signals (f_{R}, f_{N}, φ_{R}, φ_{N}) to control the operation of said shift register (3, 4) such that the data in said shift register (3, 4) are passed through to the next of said serially connected flip-flops without latching at one of said flip-flops which is connected by one (BLₓ) of said bit lines (BL₁ to BL_{N+1}) to a defective column, the control means (8, 30, 31; 8, 32, 33) being so operative that said bit line (BLₓ) connecting said one of said flip-flops to said defective column of said memory cell array (1) is cut-off by one (f_{R}) of said control signals, and said one of said flip-flops is inhibited from holding the data by another (φ_{R}) of said control signals.

2. A device according to claim 1, wherein said shift register (3, 4) comprises one or more write shift registers (4) and one or more read shift registers (3).

3. A device according to claim 1 or claim 2, wherein said control means (8, 30, 31; 8, 32, 33) includes a fuse ROM (8) for storing erroneous bit data of said defective column, and a generator (30, 31; 32, 33) for generating some (φ_{R}, φ_{N}) of said control signals by a logical process using a clock signal (φ_{CK}) to shift the data in the shift register (3, 4).

## Patentansprüche

1. Halbleiterspeichervorrichtung zur Speicherung von Videodaten, wobei die Speichervorrichtung eine Speicherzellenanordnung (1) mit mehreren Speicherzellen aufweist, die in einer Matrix mit mehreren Zeilen und mehreren Spalten angeordnet ist, wobei die Speichervorrichtung **gekennzeichnet ist durch:**
ein Schieberegister (3, 4) umfassend mehrere seriell verbundene Flipflops, um Daten in diese zu verschieben, wobei das Schieberegister (3, 4) parallel mit den Spalten der Speicherzellenanordnung (1) über jeweilige Bitleitungen (BL₁ bis BL_{N+1}) verbunden ist und das Schieberegister (3, 4) ausgebildet ist, Daten parallel von der Speicherzellenanordnung (1) zu empfangen oder dieser auszugeben, und ebenfalls ausgebildet ist, Daten seriell nach außerhalb der Vorrichtung auszugeben oder von außerhalb der Vorrichtung zu empfangen; und
eine Steuereinrichtung (8, 30, 31; 8, 32, 33) zur Erzeugung von Steuersignalen (f_{R}, f_{N}, φ_{R}, φ_{N}) zur Steuerung des Betriebes des Schieberegisters (3, 4) derart, daß die Daten in dem Schieberegister (3, 4) zu dem nächsten der seriell verbundenen Flipflops ohne Einrasten bei einem dieser Flipflops weitergegeben werden, das durch eine (BLₓ) der Bitleitungen (BL₁ bis BL_{N+1}) mit einer defekten Spalte verbunden ist, wobei die Steuereinrichtung (8, 30, 31; 8, 32, 33) so arbeitet, daß die Bitleitung (Blₓ), die dieses eine der Flipflops mit der defekten Spalte der Speicherzellenanordnung (1) verbindet, durch eines (f_{R}) der Steuersignale unterbrochen wird und das eine der Flipflops durch ein anderes (φ_{R}) der Steuersignale gehindert wird, die Daten zu halten.

2. Vorrichtung gemäß Anspruch 1,
wobei das Schieberegister (3, 4) eines oder mehrere Schreibeschieberegister (4) und eines oder mehrere Leseschieberegister (3) aufweist.

3. Vorrichtung gemäß Anspruch 1 oder 2,
wobei die Steuereinrichtung (8, 30, 31; 8, 32, 33) eine Fuse-ROM (8) zur Speicherung von fehlerhaften Bitdaten der defekten Spalte und eine Erzeugungseinrichtung (30, 31; 32, 33) zur Erzeugung einiger (φ_{R}, φ_{N}) der Steuersignale durch eine Logikprozedur mittels eines Taktsignales (φ_{CK}) zur Verschiebung der Daten im Schieberegister (3, 4) aufweist.

## Revendications

1. Dispositif de mémoire à semiconducteurs pour mémoriser des données vidéo, le dispositif de mémoire comportant un réseau de cellules de mémoire (1) comprenant une pluralité de cellules de mémoire disposées en matrice comprenant une pluralité de lignes et une pluralité de colonnes, et le dispositif de mémoire étant caractérisé par :
un registre à décalage (3, 4) comprenant une pluralité de bascules montées en série pour décaler des données dans celui-ci, ledit registre à décalage (3, 4) étant monté en parallèle avec lesdites colonnes du réseau de cellules de mémoire (1) par l'intermédiaire de lignes de transmission de bit respectives (BL₁ à BL_{N+1}) et ledit registre à décalage (3, 4) étant apte à entrer ou à délivrer des données en parallèle depuis ou vers ledit réseau de cellules de mémoire (1) et étant également apte à délivrer ou à entrer des données en série à ou depuis l'extérieur du dispositif; et
des moyens de commande (8, 30, 31; 8, 32, 33) pour générer des signaux de commande (f_{R}, f_{N}, φ_{R}, φ_{N}) pour commander le fonctionnement dudit registre à décalage (3, 4) de telle sorte que les données dans ledit registre à décalage (3, 4) sont transmises à la suivante desdites bascules montées en série sans verrouillage dans l'une desdites bascules qui est reliée par l'une (BLₓ) desdites lignes de transmission de bit (BL₁ à BL_{N+1}) à une colonne défectueuse, les moyens de commande (8, 30, 31; 8, 32, 33) fonctionnant de sorte que ladite ligne de transmission de bit (BLₓ) reliant ladite première desdites bascules à ladite colonne défectueuse dudit réseau de cellules de mémoire (1) est bloquée par l'un (f_{R}) desdits signaux de commande, et ladite première desdites bascules est empêchée de maintenir les données par un autre (φ_{R}) desdits signaux de commande.

2. Dispositif selon la revendication 1, dans lequel ledit registre à décalage (3, 4) comporte un ou plusieurs registres à décalage d'écriture (4) et un ou plusieurs registres à décalage de lecture (3).

3. Dispositif selon la revendication 1 ou la revendication 2, dans lequel lesdits moyens de commande (8, 30, 31; 8, 32, 33) comprennent une ROM à fusibles (8) pour mémoriser des données de bit erronées de ladite colonne défectueuse, et un générateur (30, 31; 32, 33) pour générer certains (φ_{R}, φ_{N}) desdits signaux de commande par un processus logique en utilisant un signal d'horloge (φ_{CK}) pour déplacer les données dans le registre à décalage (3, 4).
